# EUROPEAN PATENT APPLICATION

(11) **EP 1 693 840 A1**
(43) Date of publication of application: **23.08.2006**
(21) Application number: 06250825.4
(22) Date of filing: 16.02.2006
(51) Int. Cl.: G11B 9/02, G11B 9/00, H01L 21/02

(54) **DATA RECORDING MEDIUM INCLUDING FERROELECTRIC LAYER AND METHOD OF MANUFACTURING THE SAME**

(30) Priority: 17.02.2005 KR 2005013136; 04.03.2005 US 658151 P
(71) Applicant: Samsung Electronics Co., Ltd., Suwon-si, Gyeonggi-Do (KR)
(72) Inventor: Seung-bum, Hong, 507-1305 Hayan Maeul, Seongnam-si Gyeonggi-do (KR); Kwang-soo, No, c/o Department of Materials Science, Yuseong-gu Daejeon-si (KR); Seung-hyun, Kim, c/o Inostek Co., Ltd., Sangrok-gu Ansan-si Gyeonggi-do (KR); Yun-seok, Kim, Namyangju-si Gyeonggi-do (KR)
(74) Representative: Greene, Simon Kenneth

(57) **Abstract**

A data recording medium including a ferroelectric layer and a method of manufacturing the same are provided. In the data recording medium, a barrier layer, a conductive layer, and a seed layer are sequentially stacked on a substrate. A data recording layer is formed on the seed layer and has a vertical residual polarization.

## Description

The present invention relates to a recording medium and a method of manufacturing the same, and more particularly, to a data recording medium including a ferroelectric layer and a method of manufacturing the same.

With the development of Internet related technologies, needs for recording media capable of storing high-capacity data such as moving pictures are increasing. Also, needs which want to freely use the data stored in the recording media while moving. The increase of the needs is one of a number of important factors in leading the next-generation data recording media markets.

Recording media that can store high-capacity data and devices that can write data to the recording media and read the recorded data are the core of the data recording media markets.

Portable nonvolatile data recording media can be classified into solid-state memories (e.g., flash memory) and disk type memories (e.g., hard disk).

Since solid-state memories are only expected to reach several gigabyte (GB) capacity in the near future, they are unsuitable as mass data storage devices. Accordingly, solid-state memories are expected to be used for high-speed operations like in personal computers (PCs). Also, It is expected that disk type memories will be used as main storage devices.

Hard disks that are installed in portable devices and use magnetic recording schemes are expected to reach 10-GB capacity in the near future. However, a magnetic recording density of more than 10 GB is difficult to achieve due to a superparamagnetic effect.

For these reasons, a scanning probe has recently been used as a recording and reproducing device, and memories using ferroelectric layers as recording media are being introduced.

The use of the scanning probe, that is, a scanning probe microscope (SPM) technology, enables the probing of a region ranging from several nanometers to several ten nanometers. Also, unlike magnetic recording media, these memories are not influenced by the superparamagnetic effect because the ferroelectric layer is used as the recording medium. Therefore, compared with magnetic recording media, the recording density can be increased.

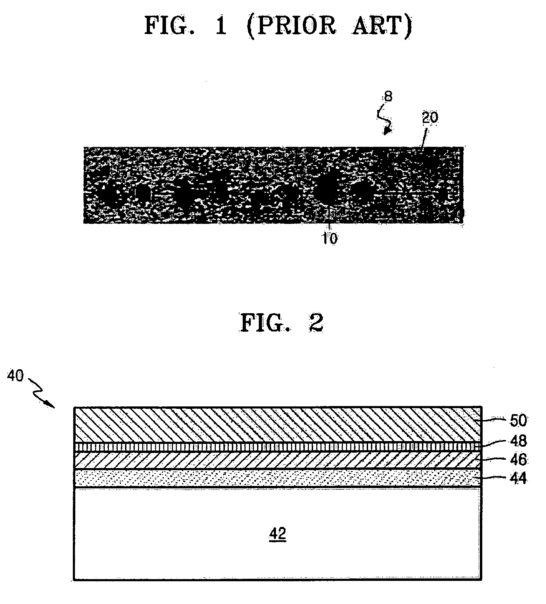

However, data recording media introduced up to now, specifically media using the ferroelectric layer as the data recording material layer, have large bit size (that is, the bit data region in the ferroelectric layer) deviation. This fact can be observed in FIG. 1. If the bit size deviation is large, the bit size is not uniform. Consequently, it is difficult to increase the recording density.

FIG. 1 is a photographic image of a conventional data recording medium 8 using a ferroelectric layer as a data recording material layer. In FIG. 1, a reference numeral 10 represents regions (dark regions) where bit data 1 is recorded, and a reference numeral 20 represents regions where bit data 0 is recorded.

Referring to FIG. 1, when comparing sizes of the regions 10 where the bit data 1 is recorded, it can be observed with the naked eyes that the size deviation of the regions 10 is large. In FIG. 1, the average size of the regions 10 is about 33 nm and the deviation is about 14 nm.

The present invention provides a data recording medium capable of increasing data recording density by reducing bit size deviation.

The present invention also provides a method of manufacturing the data recording medium.

According to an aspect of the present invention, there is provided a data recording medium including: a substrate; a barrier layer stacked on the substrate; a conductive layer stacked on the barrier layer; a seed layer formed on the conductive layer; and a data recording layer formed on the seed layer, the data recording layer having a vertical residual polarization.

The thickness of the seed layer may be 5 nm or less and the seed layer may be one of a TiO₂ layer, a Bi₂O₃ layer, and a PbTiO₃ layer.

The thickness of the data recording layer may be 50 nm or less.

The data recording layer may be one of a PZT (lead zirconate titanate) layer, a BST (barium strontium titanate) layer, a SBT (strontium bismuth titanate) layer, and a BLT (bismuth lanthanum titanate) layer.

The data recording layer may have a grain size of 10 nm or less.

When the data recording layer is formed of PZT, a composition ratio (Zr/Ti) of zirconium and titanium may be one of 25/75 and 40/60.

According to another aspect of the present invention, there is provided a method of manufacturing a data recording medium, including: sequentially stacking a barrier layer and a conductive layer on a substrate; forming a seed layer on the conductive layer; and forming a ferroelectric layer on the seed layer.

The forming of a seed layer may include: spin coating a material layer for the seed layer on the conductive layer; drying the spin coated material layer; and annealing the dried material layer.

The thickness of the seed layer may be 5 nm or less and the seed layer may be one of a TiO₂ layer, a Bi₂O₃ layer, and a PbTiO₃ layer.

The forming of a ferroelectric layer may include: spin coating a material layer for the ferroelectric layer on the seed layer; drying the spin coated material layer; repeating the spin coating and the drying as many as a predetermined number of times; and annealing the dried material layer.

The annealing may be performed at 550-650°C for 110 seconds using a RTA process.

The thickness of the ferroelectric layer may be 50 nm or less and the ferroelectric layer may be one of a PZT layer, a BST layer, a SBT layer, and a BLT layer.

Accordingly, the recording media of the present invention can uniformly record bit data and increase recording density.

The above and other features and advantages of the present invention will become more apparent by describing in detail exemplary embodiments thereof with reference to the attached drawings in which:
FIG. 1 is a photographic image of regions where bit data values 1 are recorded in a conventional data recording medium using a ferroelectric layer as a data recording layer;
FIG. 2 is a sectional view of a data recording medium according to an embodiment of the present invention;
FIG. 3 is a graph illustrating a surface potential according to a composition ratio (Zr/Ti) of zirconium (Zr) and titanium (Ti) in a ferroelectric layer, when the ferroelectric layer is a PZT layer in the data recording medium of FIG. 2;
FIG. 4 is a graph illustrating a size deviation of bit data regions in the ferroelectric layer of FIG. 2 according to a ratio (bit size/grain size) of a unit bit data region size in the ferroelectric layer to a grain size of the ferroelectric layer;
FIGS. 5 through 7 are flowcharts illustrating a method of manufacturing the data recording medium illustrated in FIG. 2;
FIG. 8 is a photographic image of a grain size of a ferroelectric layer, formed of PZT, when the ferroelectric layer is directly formed on a conductive layer without any seed layer;
FIG. 9 is a partially enlarged photographic image of the PZT layer illustrated in FIG. 8;
FIG. 10 is a photographic image of a grain size of a ferroelectric layer, formed of PZT, formed on a seed layer after the seed layer is formed on a conductive layer using the method illustrated in FIGS. 5 through 7;
FIG. 11 is a partially enlarged photographic image of a PZT layer illustrated in FIG. 10;
FIG. 12 is a graph of an X-ray diffraction pattern of the PZT layer of FIG. 10;
FIG. 13 is a photographic image illustrating a bit data 1 recorded in a recording medium according to an embodiment of the present invention; and
FIG. 14 is a graph of a signal characteristic in a read operation of the recording medium illustrated in FIG. 13.

Hereinafter, a data recording medium including a ferroelectric layer and a method of manufacturing the same will be described in detail with reference to the accompanying drawings. In the drawings, the thicknesses of layers and regions are exaggerated for clarity.

First, a data recording medium according to an embodiment of the present invention will be described.

FIG. 2 is a sectional view showing composition of a recording medium 40. Referring to FIG. 2, a barrier layer 44 and a conductive layer 46 are sequentially disposed on a substrate 42. A seed layer 48 is disposed on the conductive layer 46, and a ferroelectric layer 50 is disposed on the seed layer 48. Bit data are recorded in the ferroelectric layer 50. The substrate 42 may be an oxidized silicon substrate. The barrier layer 44 prevents carriers from moving between the conductive layer 46 and the substrate 42. The barrier layer 44 may be formed of titanium oxide (TiO₂). The conductive layer 46 may be a sequentially stacked platinum and titanium (Pt/Ti) layer. Also, the conductive layer 46 may be a single layer. The seed layer 48 increases nucleation site. Due to the seed layer 48, a grain size of the ferroelectric layer 50 is reduced. For example, when the ferroelectric layer 50 is formed of PZT, the seed layer 48 may be formed of titanium oxide. The ferroelectric layer 50 is used as a data recording layer. A material that is used as the seed layer 48 may be different depending on a material that is used as the ferroelectric layer 50. For example, when the ferroelectric layer 50 is formed of SBT, the seed layer 48 may be formed of bismuth oxide (Bi₂O₃). In addition, the seed layer 48 may be formed of PbTiO₃. The seed layer 48 has a predetermined thickness optimized to increasing the nucleation site. For example, when the seed layer 48 is formed of titanium oxide, the thickness of the seed layer 48 may be 5 nm or less. The ferroelectric layer 50 may also be formed of BST, SBT, or BLT, in addition to PZT.

The grain size of the ferroelectric layer 50 is preferably smaller than the size of bit data recorded in the ferroelectric layer 50. However, the grain size may also be greater than the size of the bit data. When the ferroelectric layer 50 is formed of PZT, the grains size of the ferroelectric layer 50 may be 10 nm or less. When the ferroelectric layer 50 is formed of PZT, the thickness of the ferroelectric layer 50 may be 50 nm or less. The thickness of the ferroelectric layer 50 may be different depending on the ferroelectric material used to form the ferroelectric layer.

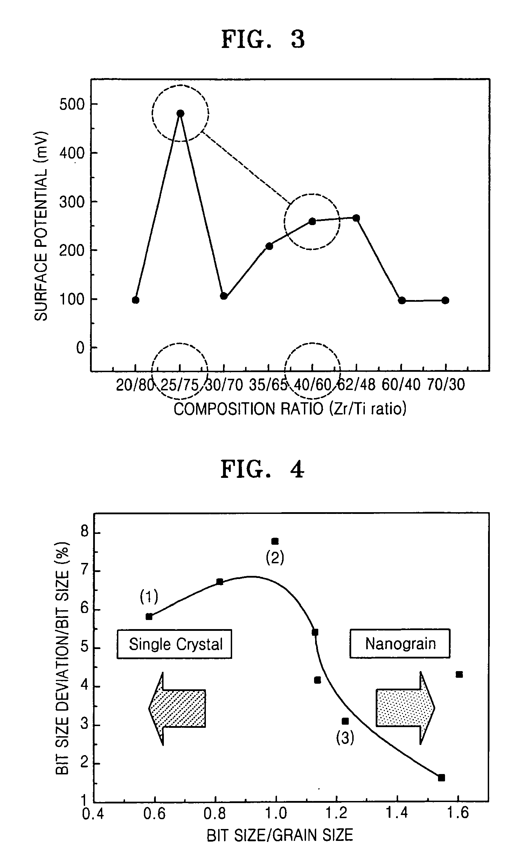

Meanwhile, a surface potential of the ferroelectric layer 50 was measured while changing the composition of the ferroelectric layer 50 so as to find the correlation between the composition of the ferroelectric layer 50 and the surface potential. FIG. 3 is a graph illustrating the surface potential of the ferroelectric layer 50 according to a composition ratio (Zr/Ti) of zirconium and titanium (Ti) in the ferroelectric layer 50, when the ferroelectric layer is formed of PZT. The surface potential was measured using a Kelvin force microscope (KFM).

Referring to FIG. 3, when the Zr/Ti ratio is 25/75 (hereinafter, referred to as a first case), the ferroelectric layer 50 has the highest surface potential. When the Zr/Ti ratio is 52/48 (hereinafter, referred to a second case), the ferroelectric layer 50 has the second highest surface potential. When the Zr/Ti ratio is 40/60 (hereinafter, referred to as a third case), the ferroelectric layer 50 has the third highest surface potential. Although the second case has a higher surface potential than the third case, structural characteristics (e.g., preferred orientation) other than the surface potential are degraded and a pyrochlore phase, which indicates non-ferroelectric part exists in the ferroelectric layer 50, is exhibited. For this reason, the second case is worse than the third case. Therefore, if selecting one of the three cases, it is desirable to select the first case. If selecting two cases, it is desirable to select the first and third cases.

From the result of FIG. 3, when the ferroelectric layer 50 of FIG. 2 is formed of PZT, it is desirable that the ferroelectric layer 50 is formed of PZT (Pb(Zr_{0.25}Ti_{0.75})0₃) with a Zr/Ti ratio of 25/75 or PZT (Pb(Zr_{0.40}Ti_{0.60})O₃) with a Zr/Ti ratio of 40/60.

FIG. 4 is a graph illustrating a size deviation of bit data in the ferroelectric layer 50 according to a ratio (hereinafter, bit size/grain size) of a unit bit data size recorded in the ferroelectric layer 50 to a grain size of the ferroelectric layer 50.

Referring to FIG. 4, the size deviation of the bit data when the bit size/grain size ratio is greater or less than 1 is smaller than the size deviation of the bit data when the bit size/grain size ratio is equal to 1. This result is derived from the interaction between the domain and the grain of the ferroelectric layer 50. It can be seen from the graph of FIG. 3 that the size deviation of the bit data of the ferroelectric layer 50 in the recording medium 40 according to the current embodiment of the present invention is very small. For example, because the grain size of the ferroelectric layer 50 in the recording medium 40 is about 10 nm, the bit size/grain size ratio in the ferroelectric layer 50 is about 3 when the size of the bit data regions is 30 nm. Therefore, from the graph of FIG. 4, the size deviation of the bit data regions approaches 1%. When the size deviation is converted into the size of bit data, the size of the bit data is about 30 nm and the size deviation of the bit data is about 0.3 nm. This is much less than the conventional size deviation of 14 nm. Accordingly, the size of the bit data in the ferroelectric layer 50 in the recording medium 40 according to the current embodiment of the present invention is very uniform, which is incomparable to the

### prior art.

A method of manufacturing the recording medium 40 of FIG. 2 will now be described with reference to FIGS. 2 and 5 through 7.

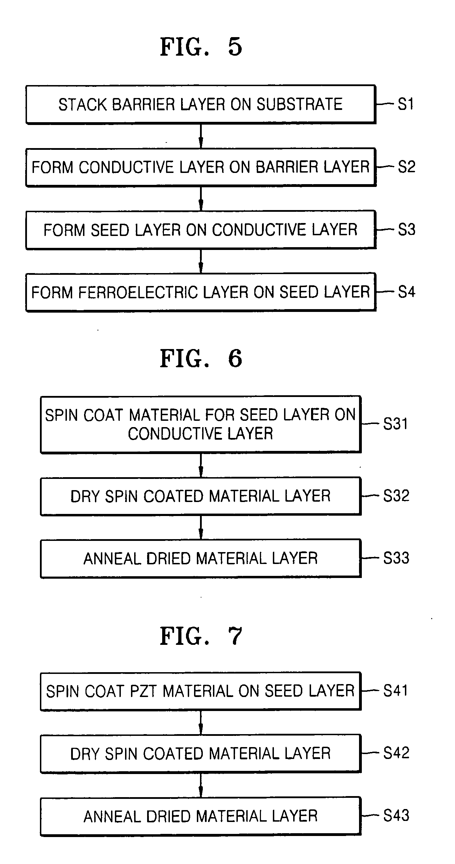

Referring to FIGS. 2 and 5, in operation S1, a barrier layer 44 is stacked on a substrate 40. The substrate 40 may be a silicon substrate, a surface of which is oxidized. The barrier layer 44 may be formed of titanium oxide. In operation S2, a conductive layer 46 is formed on the barrier layer 44. The conductive layer may be a single layer or a multi layer. Referring to the latter, the conductive layer 46 may be a sequentially stacked platinum and titanium (Pt/Ti) layer. The barrier layer 44 and the conductive layer 46 are formed to a thickness at which they can perform functions independent of each other. Then, in operation S3, a seed layer 48 is formed on the conductive layer 46. In operation S4, a ferroelectric layer 50 is formed on the seed layer 48. A material used to form the seed layer 48 and its thickness may be different depending on the ferroelectric layer 50. For example, when the ferroelectric layer 50 is formed of PZT, the seed layer 48 may be formed of titanium oxide. At this point, the thickness of the seed layer 48 may be 5 nm or less. When the ferroelectric layer 50 is formed of BST, SBT layer, or BLT, the seed layer 48 may be formed of bismuth oxide (Bi₂O₃). In addition, the seed layer **48** may be formed of PbTiO₃. The seed layer 48 can be formed to a thickness other than 5 nm. When the ferroelectric layer 50 is formed of PZT layer, the ferroelectric layer 50 may be formed to a thickness of 50 nm or less. When the ferroelectric layer 50 is formed of materials other than PZT, the thickness of the ferroelectric layer 50 may be different from 50 nm. In operation S4, the grain size of the ferroelectric layer 50 may be about 10 nm or less. In addition, that the ferroelectric layer 50 may be formed to have a composition ratio such that the surface potential is high. For example, when the ferroelectric layer 50 is formed of PZT, the ferroelectric layer 50 is formed such that the Zr/Ti ratio becomes 25/75 or 40/60.

When the ferroelectric layer 50 is formed of PZT, the grain size of the ferroelectric layer 50 can be reduced by forming the seed layer 48 and the ferroelectric layer 50 according to the flowcharts of FIGS. 6 and 7, respectively.

Referring to FIG. 6, the seed layer 48 is formed through operations S31, **S32** and **S33.** In operation S31, a raw material of the seed layer is spin coated on the conductive layer 46. At this point, the spin coating can be performed at 4,000 rpm for 20 seconds. Also, the seed layer material can be coated to an appropriate thickness. In operation S32, the spin coated material layer is dried. The drying operation can be performed at 300°C for five minutes. In operation S33, the dried material layer is annealed. The annealing can be performed at 550-650°C for 110 seconds using a rapid thermal annealing (RTA) process.

Referring to FIG. 7, the ferroelectric layer 50 is formed through operations S41, S42 and S43. Operations S41 and S42 are repeated two more times, and may be repeated four times, and then operation S43 is performed.

In operation S41, a PZT raw material is spin coated on the seed layer 48. At this time, the spin coating can be performed at 4,000 rpm for 20 seconds. The PZT raw material can be coated to an appropriate thickness.

In operation S42, the spin coated material layer is dried. The drying operation can be performed at 300°C for five minutes.

In operation S43, the dried material layer is annealed. The annealing operation can be performed at 550-650°C for 110 seconds using an RTA apparatus. During this operation, the ferroelectric layer 50 is crystallized.

Because the seed layer 48 is formed between the conductive layer 46 and the ferroelectric layer 50, the ferroelectric layer 50 can maintain a crystal state while having nano-sized grains.

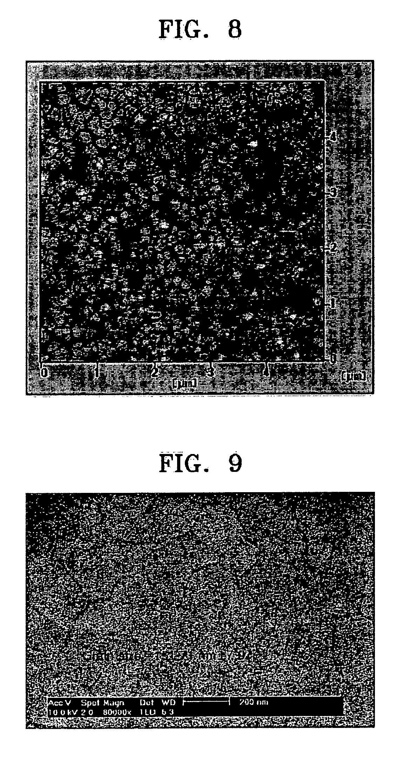

The effect of the seed layer 48 will be understood more fully from FIGS. 8 and 9.

FIG. 8 is a photographic image of a grain size of a PZT layer formed on the conductive layer 46 without the seed layer 48. This PZT layer will be referred to as a first PZT layer. FIG. 9 is a partially enlarged photographic image of the PZT layer of FIG. 8 so as to measure the grain size. In FIG. 9, an average size of the grain G is about 151.71 nm. The first PZT layer of FIG. 8 has a Zr/Ti ratio of 25/75 and an RTA process was performed thereon at 650°C.

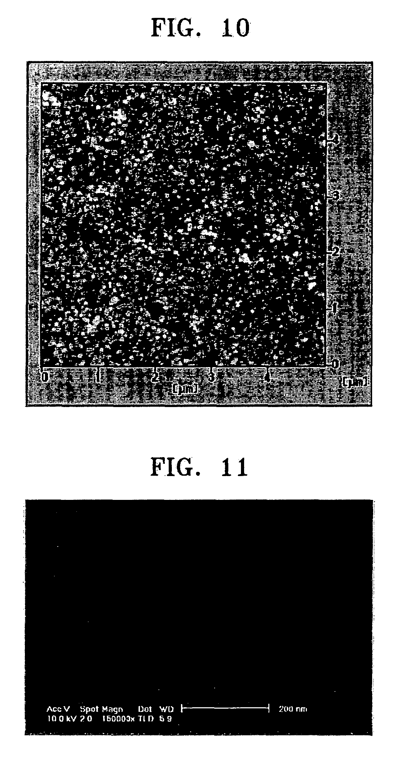

FIG. 10 is photographic image of the grain size of a PZT layer formed on the seed layer 48 after the seed layer 48 is formed on the conductive layer 46. This PZT layer will be referred to as a second PZT layer. FIG. 11 is a partially enlarged photographic image of the PZT layer of FIG. 10 so as to measure the grain size. Since the grains are very small, it is difficult to see the grains from FIG. 11. As the measurement result, the average size of the grains was 10 nm. An RTA process was performed on the second PZT layer at 550°C and the composition ratio of the second PZT layer was equal to that of the first PZT layer.

In comparing FIGS. 8 and 10 and FIGS. 9 and 11, when the seed layer 48 is formed between the conductive layer 46 and the ferroelectric layer 50, the grain size of the ferroelectric layer 50 becomes much smaller.

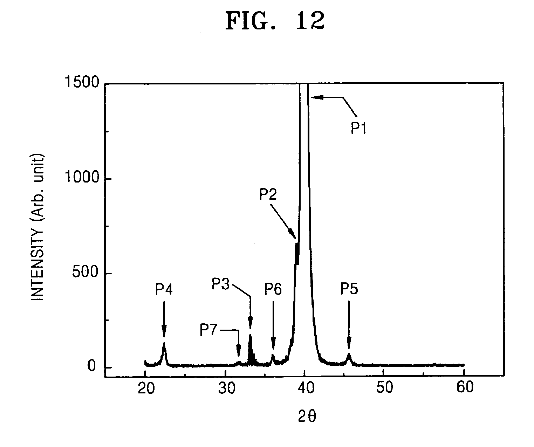

FIG. 12 is a graph of an X-ray diffraction pattern of the second PZT layer.

Referring to FIG. 12, a first peak P1 exhibits the existence of platinum (Pt) with a (111) plane, and a second peak P2 exhibits the existence of perovskite crystal with a (111) plane.

A third peak P3 exhibits the existence of silicon, and a fourth peak P4 exhibits the existence of perovskite crystal with a (100) plane. Also, a fifth peak P5 exhibits the existence of perovskite crystal with a (200) plane, and a sixth peak P6 exhibits the existence of platinum having a beta crystal structure with a (111) plane. Also, a seventh peak P7 exhibits the existence of perovskite crystal with a (110) plane. From the first and second peaks P1 and P2 and the fourth to seventh peaks P4 to P7, it can be seen that the second PZT layer is in a crystal state. The results of FIGS. 10 and 12 indicate that the ferroelectric layer of the recording medium according to an embodiment of the present invention has a nano grain size and is in a crystal state, and the ferroelectric layer has an orientation along a (111) direction. Therefore, although the ferroelectric layer has a nano grain size, it can have a polarity characteristic.

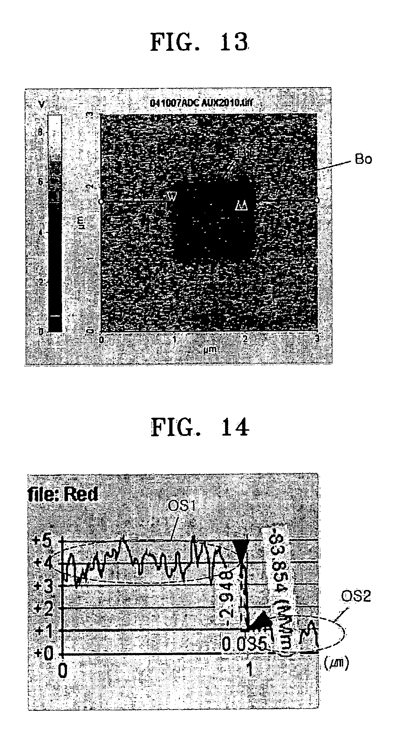

FIG. 13 is a photographic image illustrating a bit data value 1 recorded in a recording medium according to an embodiment of the present invention, and FIG. 14 is a graph of a signal characteristic when reading the recording medium illustrated in FIG. 13.

In FIG. 13, a reference symbol B1 represents a first region where a bit data value1 is recorded in the ferroelectric layer, and a reference symbol B0 represents a second region where a bit data value 0 is recorded in the ferroelectric layer.

Referring to FIG. 14, a first output signal OS1 represents a signal variation occurring in the second region B0 where the bit data value 0 is recorded, when reading the recording medium of FIG. 13 from left to right using a probe. A second output signal OS2 represents a signal variation occurring in the first region B1 where the bit data value 1 is recorded. Also, in FIG. 14, "0.035" represents a transition width from the first output signal OS1 to the second output signal OS2. At this time, the unit of the distance is µm.

Considering an increase of the reading speed and recording density in the recording medium, after the probe reads the second region B0 where the bit data 0 is recorded, it is better as the time of recognizing the existence of the first region B1 where the bit data value 1 is recorded becomes shorter. Therefore, the transition width should be made as short as possible. The transition width (0.035 µm (35 nm)) between the first and second output signals OS1 and OS2 is a distance corresponding to a radius of the probe and is close to the maximum resolution of the probe.

According to an embodiment of the present invention, a thin passivation layer can be formed so as to prevent a physical contact, but allow an electrical contact, of the probe and the ferroelectric layer 50 on a surface of the ferroelectric layer 50. Also, considering that horizontal recording media are being used now, the manufacturing methods of FIGS. 5 through 7 can be applied to horizontal recording media. Further, the manufacturing methods according to an embodiment of the present invention can be applied to a double-layer data storage medium where ferroelectric layers are provided above and below a substrate.

As described above, according to the recording medium of the present invention, because the grain size of the ferroelectric layer is much smaller than the bit size (that is, the bit data region in the ferroelectric layer), the deviation of the bit size (that is, the deviation of the bit data region in the ferroelectric layer) can be reduced. Also, according to the recording medium of the present invention, the transition width between the region where bit data values 0 are recorded and the region where bit data values1 are recorded can be reduced close to the maximum resolution of the probe. Therefore, when using the recording medium of the present invention, bit data can be uniformly recorded and the recording density can be increased.

While the present invention has been particularly shown and described with reference to exemplary embodiments thereof, it will be understood by those of ordinary skill in the art that various changes in form and details may be made therein without departing from the scope of the present invention as defined by the following claims.

## Claims

1. A data recording medium (40) comprising:
a substrate (42);
a barrier layer (44) stacked on the substrate (42);
a conductive layer (46) stacked on the barrier layer (44);
a seed layer (48) formed on the conductive layer (46); and
a data recording layer (50) formed on the seed layer (48), the data recording layer having a vertical residual polarization.

2. The data recording medium of claim 1, where the thickness of the seed layer (48) is 5 nm or less.

3. The data recording media of claim 2, wherein the seed layer(48) is one of a TiO₂ layer, a Bi₂O₃ layer, and a PbTiO₃ layer.

4. The data recording medium of claim 1, 2 or 3" wherein the thickness of the data recording layer (50) is 50 nm or less.

5. The data recording medium of any preceding claim, wherein the data recording layer (50) is one of a PZT layer, a BST layer, a SBT layer, and a BLT layer.

6. The data recording medium of any preceding claim, wherein the data recording layer (50) has a grain size of 10 nm or less.

7. The data recording medium of claim 5, wherein the data recording layer (50) is formed of PZT and a composition ratio (Zr/Ti) of zirconium and titanium in the PZT is one of 25/75 and 40/60.

8. A method of manufacturing a data recording medium, the method comprising the steps of:
sequentially stacking a barrier layer (44) and a conductive layer (46) on a substrate (42);
forming a seed layer (48) on the conductive layer (46); and
forming a ferroelectric layer (50) on the seed layer (48).

9. The method of claim 8, wherein the step of forming of a seed layer (48) comprises:
spin coating a material layer for the seed layer (48) on the conductive layer (46);
drying the spin coated material layer; and
annealing the dried material layer.

10. The method of claim 9, wherein the spin coating is performed at 4,000 rpm for 20 seconds.

11. The method of claim 9 or 10, wherein the drying is performed at 300°C for 5 minutes.

12. The method of any of claims 9 to 11, wherein the annealing is performed at 550-650°C for 110 seconds using a rapid thermal annealing (RTA) process.

13. The method of any of claims 8 to 12, wherein the thickness of the seed layer (48) is 5 nm or less.

14. The method of any of claims 8 to 13, wherein the seed layer is one of a TiO₂ layer, a Bi₂O₃ layer, and a PbTiO₃ layer.

15. The method of any of claims 8 to 14, wherein the forming of a ferroelectric layer comprises:
spin coating a material layer for the ferroelectric layer (50) on the seed layer (48);
drying the spin coated material layer;
repeating the spin coating and the drying as many as a predetermined number of times; and
annealing the dried material layer.

16. The method of claim 15, wherein the spin coating is performed at 4,000 rpm for 20 seconds.

17. The method of claim 15 or 16, wherein the drying is performed at 300°C for 5 minutes.

18. The method of claim 15, 16 or 17, wherein the annealing is performed at 550-650°C for 110 seconds using a RTA process.

19. The method of any of claims 8 to 18, wherein the thickness of the ferroelectric layer (50) is 50 nm or less.

20. The method of any of claims 8 to 19, wherein the ferroelectric layer(50) is one of a PZT layer, a BST layer, a SBT layer, and a BLT layer.

21. The method of any of claims 8 to 20, wherein the ferroelectric layer has a grain size of 10 nm or less.

22. The method of claim 20, wherein when the data recording layer is formed of PZT, a composition ratio (Zr/Ti) of zirconium and titanium is one of 25/75 and 40/60.
